Europäisches Patentamt

European Patent Office

Office européen des brevets

(11) Numéro de publication : **0 013 523**
**B1**

# FASCICULE DE BREVET EUROPÉEN

(45) Date de publication du fascicule du brevet :
26.10.83

(51) Int. Cl.³ : **G 11 C 11/24, G 11 C 11/34**

(21) Numéro de dépôt : **79401040.5**

(22) Date de dépôt : **19.12.79**

(54) **Procédé d'inscription d'un caractère témoin dans une mémoire à stockage de charges électriques et dispositif obtenu par ce procédé.**

(30) Priorité : **27.12.78 FR 7836543**

(43) Date de publication de la demande :
**23.07.80 Bulletin 80/15**

(45) Mention de la délivrance du brevet :
**26.10.83 Bulletin 83/43**

(84) Etats contractants désignés :
**BE CH DE GB IT NL SE**

(56) Documents cités :
**DE A 2 516 124
FR A 2 302 568**

**IBM TECHNICAL DISCLOSURE BULLETIN,
vol. 20, no. 11A, avril 1978 New York US JOHN-
SON & STINSON : « Master storage cell to initiate
refreshing of dynamic memory chip »,
pages 4401-4403**

(73) Titulaire : **COMPAGNIE INTERNATIONALE POUR
L'INFORMATIQUE CII - HONEYWELL BULL (dite
CII-HB)
94, avenue Gambetta
F-75020 Paris (FR)**

(72) Inventeur : **Moilier, Jean Henri
20, rue du Chemin de Fer
F-78380 Bougival (FR)**

(74) Mandataire : **Doireau, Marc
CII-Honeywell Bull Division Propriété Industrielle 94,
avenue Gambetta Boîte Postale 33
F-75960 Paris cedex 20 (FR)**

Jouve, 18, rue St-Denis, 75001 Paris, France

## Procédé d'inscription d'un caractère témoin dans une mémoire à stockage de charges électriques et dispositif obtenu par ce procédé

La présente invention concerne un procédé d'inscription d'un caractère témoin dans une mémoire composée de cellules de stockage de charges électriques. L'invention concerne aussi un produit obtenu par ce procédé.

Les mémoires à stockage de charges électriques sont très utilisées pour mémoriser des informations codées sous forme binaire, où l'élément d'information (bit d'information) est stocké dans la mémoire sous la forme d'une charge électrique q. Le bit d'information peut prendre deux valeurs binaires 0 ou 1, ces valeurs correspondent à une charge électrique nulle ou différente de zéro.

Ces types de mémoires sont principalement réalisés à l'aide de deux types de technologie, une technologie MOS (abréviation du terme anglo-saxon Metal Oxyde Semiconducteur) et une technologie MNOS (abréviation du terme anglo-saxon Metal Nitride Oxyde Semiconducteur).

Une mémoire réalisée en technologie MOS a des temps d'accès de 450 à 1 200 ns et des temps d'effacement de l'ordre de 1 µs alors que celle réalisée en technologie MNOS a des temps d'accès de 1 µs et des temps d'effacement de l'ordre de 1 à 100 ms. Ce qui différencie beaucoup ces deux types de réalisation tient au fait qu'une mémoire MOS dynamique peut garder en mémoire une information pendant un temps voisin de 1 ms alors qu'une mémoire en technologie MNOS peut la conserver pendant des années.

Par contre elles présentent toutes les deux l'inconvénient d'être sensibles à un certain nombre de perturbations physiques extérieures. Ainsi l'exposition de ces mémoires à des rayonnements électro-magnétiques comme les ultra-violets peut modifier la grandeur électrique des charges réparties dans la mémoire et par là, modifier les informations qui sont stockées. De même, des accès répétés peuvent faire diminuer progressivement les quantités d'électricité stockées dans chacune de ces mémoires. Enfin, des défauts de régulation du générateur de courant et de tension alimentant les circuits de ces mémoires peuvent eux aussi perturber et modifier les informations qui sont ainsi mémorisées. Ces inconvénients sont donc néfastes à l'intégrité et à la sûreté des informations ainsi mémorisées.

Naturellement, plusieurs dispositifs peuvent être utilisés pour conserver l'intégrité des informations mémorisées, en disposant par exemple des écrans absorbant les radiations néfastes, en créant des cycles de régénération des charges stockées ou en prévoyant des dispositifs de coupe-circuit d'alimentation lorsque celle-ci devient défaillante. Malgré la qualité de ces dispositifs rendant pratiquement inaltérables les informations contenues dans ces mémoires, on ne peut jamais être certain qu'une mémoire n'a pas été exposée un certain moment à un rayonnement ou qu'un phénomène électrique s'est produit qui aurait eu pour conséquence une altération des informations mémorisées.

C'est donc un premier but de l'invention que d'introduire dans ces mémoires un moyen de contrôle permettant de savoir s'il n'y a pas eu de modification de la mémoire par d'autres voies que celles des circuits prévus à son bon fonctionnement ou par effet secondaire lors de l'utilisation de ces mêmes circuits.

Un article de la revue américaine « I.B.M. Technical Disclosure Bulletin, volume 20, n° 11A, avril 1978, pages 4401-4403 », décrit un dispositif pour commander le rafraîchissement des informations stockées dans une mémoire volatile. Ce dispositif est essentiellement constitué par une cellule auxiliaire ayant, de par sa structure, une fragilité supérieure à celle des autres cellules de la mémoire. Lorsqu'il est constaté une altération trop importante de la charge de la cellule auxiliaire, il est procédé à un rafraîchissement de cette cellule ainsi que toutes les autres cellules de la mémoire.

L'invention s'applique plus particulièrement aux mémoires non volatiles où les informations stockées n'ont pas besoin d'être rafraîchies pour être conservées. En outre, le moyen de contrôle est constitué par une cellule identique aux autres cellules de la mémoire et seule sa charge initiale est définie de façon particulière.

Un autre but de l'invention est d'assurer une protection efficace de ces moyens de contrôle lors de l'utilisation de ces mémoires, en particulier en rendant inaccesibles ces moyens de contrôle par les circuits d'adressage de la mémoire, lorsqu'une écriture d'information est effectuée dans ces mémoires. Une telle protection n'est pas envisagée dans l'article antérieur précité. Au contraire, la cellule auxiliaire est nécessairement accessible en écriture puisqu'elle doit être elle-même rafraîchie.

Ces buts sont atteints par l'objet de l'invention qui est un procédé d'inscription d'un caractère témoin dans une mémoire composée de cellules de stockage de charges électriques, caractérisé en ce qu'il consiste au cours de la fabrication des circuits devant coopérer avec la dite mémoire, à partager l'espace de la mémoire en au moins deux zones dont l'une est destinée à recevoir un caractère témoin, à charger un nombre déterminé de cellules à stockage de charge composant la zone témoin d'une quantité d'électricité inférieure où égale à celle utilisée pour l'écriture des informations binaires dans la ou les autres zones, puis à isoler la zone affectée au caractère témoin des circuits d'écriture de la mémoire en interposant entre les moyens de commande de la mémoire et la mémoire des moyens autorisant l'accès du caractère témoin en lecture et l'interdisant en écriture.

Ainsi obtenu, le caractère témoin peut avoir une fragilité plus grande que le reste des autres zones de la mémoire, de sorte qu'il puisse être détérioré avant les autres informations contenues dans la mémoire. Il sera loisible pour chaque accès à la mémoire d'effectuer un test des informations composant le caractère témoin pour vérifier que la mémoire n'a pas été plongée dans un milieu hostile et s'assurer que les informations contenues dans la mémoire peuvent ou non être utilisées valablement. Ainsi définie, l'invention peut être appliquée dans tous les systèmes de traitement de données, gros ordinateurs ou équipement de poche, où il est nécessaire de garantir à tout moment l'intégrité des informations et résout aussi le problème de la dégradation ou du vieillissement de l'information par stockage prolongé des milieux d'enregistrements sur lesquels ces informations ont été enregistrées.

D'autres caractéristiques et avantages de l'invention apparaîtront mieux à l'aide de la description et des dessins qui vont suivre.

La figure 1 représente sous forme simplifiée une cellule mémoire à stockage de charge électrique.

La figure 2A représente un schéma de principe d'une cellule mémoire réalisée en technologie MOS ou en technologie MNOS.

La figure 2B montre la constitution d'une branche de transistors MOS $Q_1$ et $Q_3$ de la figure 2A.

La figure 2C montre la constitution d'un transistor réalisé en technologie MNOS.

La figure 3 est un schéma montrant l'appareillage nécessaire à l'introduction du caractère témoin dans une mémoire à stockage de charge.

La figure 4 est un schéma montrant une mémoire à stockage de charge dans laquelle un caractère témoin est inscrit et à laquelle sont adjoints des circuits de commande autorisant l'accès du caractère témoin en mode lecture et l'interdisant en mode écriture.

La figure 5 est diagramme montrant l'évolution dans le temps des phases nécessaires à l'inscription du caractère témoin.

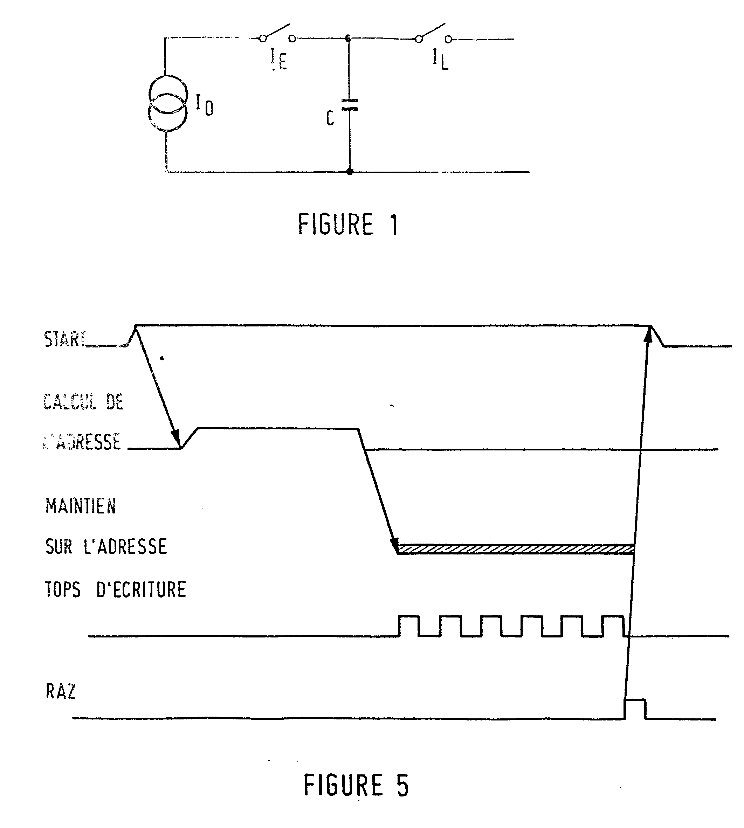

La cellule à stockage de charge de la figure 1 se compose d'un condensateur C alimenté au travers d'un interrupteur $I_E$ par un générateur de courant $I_0$. Lorsque l'interrupteur $I_E$ est fermé, le courant délivré par le générateur de courant $I_0$ circule dans le condensateur C et charge ce condensateur d'une quantité d'électricité $\Delta Q$ qui dépend du temps $\Delta t$ pendant lequel l'interrupteur $I_E$ est fermé suivant la relation $\Delta Q = I_0 \Delta t$. Dans le cas où il est donné une valeur constante au courant $I_0$ et au laps de temps $\Delta t$, la quantité d'électricité ainsi introduite dans le condensateur C se trouve être constante. En répétant ainsi $n_1$ fois les instants de fermeture de l'interrupteur $I_E$, on stocke une charge $Q_1 = n_1 I_0 \Delta t$ dans le condensateur C. Dans l'application qui intéresse l'invention, il est nécessaire de charger les cellules de stockage composant le caractère témoin d'une quantité d'électricité inférieure à celle utilisée pour mémoriser les informations autres que celles figurant dans le caractère témoin. Selon le principe qui vient d'être exposé, ce problème peut être résolu en chargeant les cellules de stockage réservées au caractère témoin d'une quantité d'électricité $Q_1 = n_1 I_0 \Delta t$ où $n_2$ correspond au nombre de répétition des instants de fermeture de l'interrupteur $I_E$. Le nombre $n_2$ devra être supérieur au nombre $n_1$ pour que la quantité d'électricité $Q_1$ soit inférieure à la quantité d'électricité $Q_2$. Les cellules une fois chargées des quantités d'électricité $Q_1$ ou $Q_2$ présentent alors aux bornes de la capacité C les différences de potentiels respectives $U_{L1} = Q1/C$ et $U_{L2} = Q2/C$ où $L_2 > U_{L1}$. Ces différences de potentiel peuvent alors être lues par des circuits extérieurs par fermeture de l'interrupteur $I_L$. Il est bien évident que dans un autre mode de réalisation non décrit ici, il serait aussi possible d'obtenir les deux charges $Q_1$ et $Q_2$ par application de deux tensions $U_1$ et $U_2$ différentes.

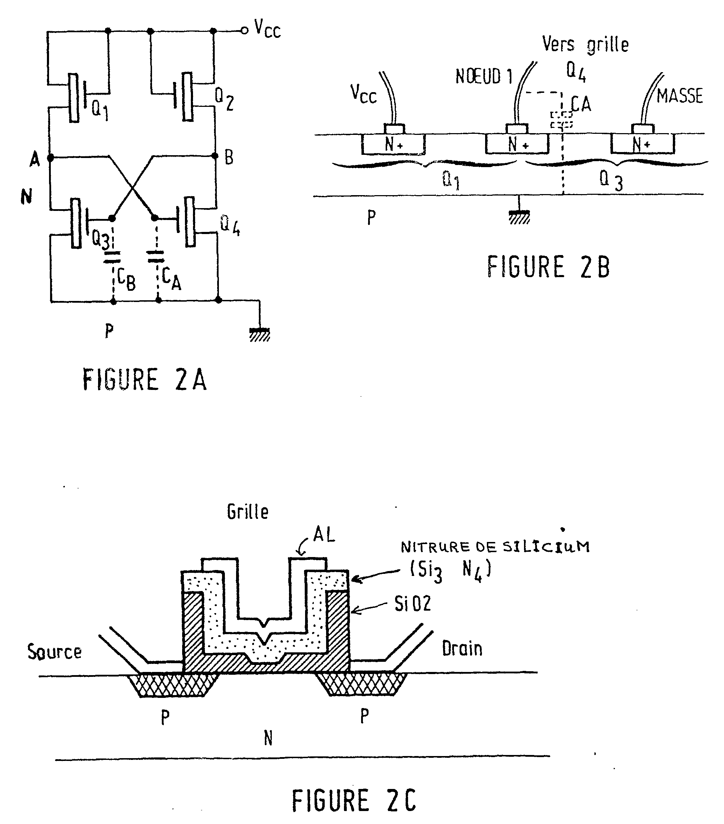

La cellule mémoire représentée à la figure 2A comprend quatre transistors. Les transistors $Q_1$ et $Q_2$ sont utilisés comme charge résistive tandis que les transistors $Q_3$ et $Q_4$ sont retrocouplés. Une information est mémorisée dans une des branches $(Q_1, Q_3)$ ou $(Q_2, Q_4)$ lorsque les transistors de l'autre branche conduisent. Cette information est conservée en l'absence de tension d'alimentation $V_{cc}$ par les capacités parasites $C_A$ ou $C_B$ de grille. Dans une réalisation en technologie MOS ces capacités se déchargent lentement dans la jonction constituée par la zone de diffusion N au niveau des nœuds A ou B et le substrat P qui est au potentiel de la masse (figure 2B). L'effet de décharge peut être éliminé par utilisation de transistor MNOS dont la constitution est montrée à la figure 2C. Sur cette figure le substrat a une conductibilité de type N et comporte deux zones de diffusion P, l'une étant reliée à l'électrode de source et l'autre à celle de drain. Sur la surface du substrat N entre les deux zones de diffusion P sont déposées successivement : une couche d'oxyde de silicium $SiO_2$, une couche de nitrure de silicium $Si_3N_4$ et une couche d'aluminium.

Lorsque ce type de transistor est normalement polarisé par des générateurs de courant et de tension extérieurs, les charges électriques circulent des zones de diffusion P vers la grille au travers de la couche très mince de $SiO_2$. Un effet tunnel se produit qui bloque ces charges électriques dans la couche de nitrure de silicium. En l'absence de toute alimentation par les générateurs extérieurs, ces charges restent localisées au niveau de la couche de nitrure de silicium.

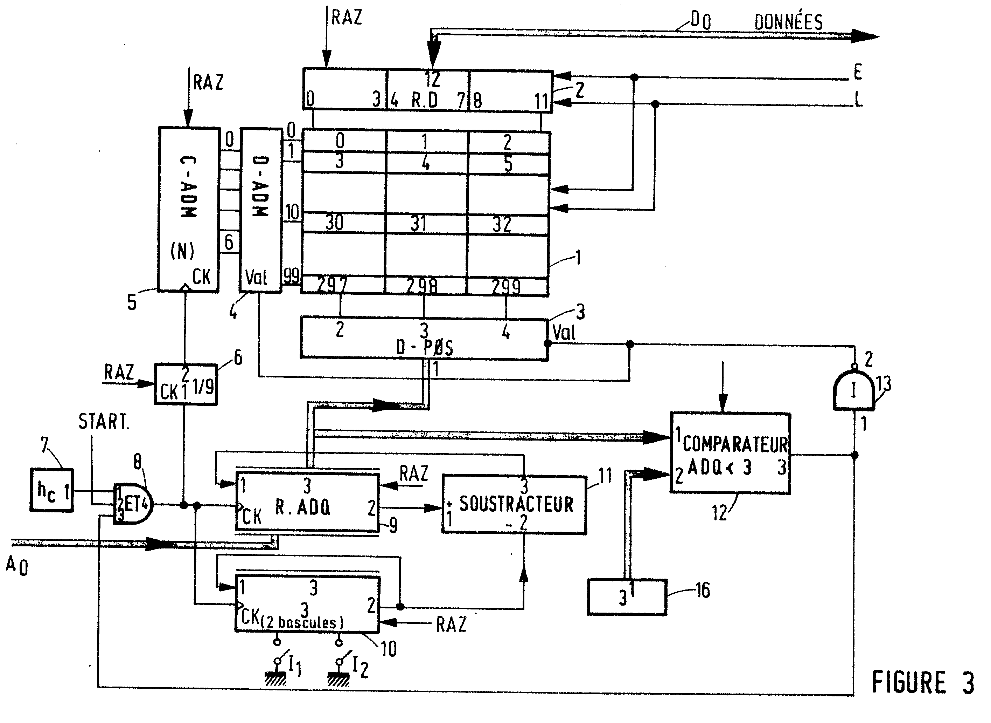

L'introduction d'un caractère témoin à l'intérieur d'une mémoire à stockage de quantité d'électricité a lieu avec le dispositif représenté à la figure 3. Sur cette figure la mémoire de stockage 1 est une mémoire à 100 lignes et 12 colonnes réalisant une capacité de 1 200 cellules de stockage. Dans l'exemple de réalisation qui est montré, la mémoire est divisée en 300 emplacements de 4 bits allant du chiffre 0 au chiffre 299. Les chiffres 0 1 2 se suivent sur la ligne 0, les chiffres 3 4 5 sur la ligne 1 et ainsi de suite ... Les 100 lignes sont sélectionnées à partir du décodeur d'adresse D.ADM 4. La position d'un emplacement de 4 bits est sélectionné sur une ligne à partir du décodeur de position D.POS 3. Le décodeur D.ADM décode les combinaisons des sorties 0 à 6 du compteur binaire C.DAM 5. Ce compteur progresse à partir de signaux binaires arrivant sur son entrée $C_K$ et générés par la sortie 2 d'un compteur 6 à quatre bascules qui est lui-même piloté sur son entrée $C_K$ par les signaux d'horloge générés par la sortie 4 de la porte ET 8.

Le registre R.ADQ 9 est un registre à décalage à 9 bascules qui contient l'adresse binaire de l'emplacement de mémoire de 4 bits à sélectionner. Il reçoit sur son entrée $C_K$ les signaux d'horloge générés par la porte ET 8. A l'initialisation, ce registre est chargé par les bits d'adresse positionnés sur la ligne d'adresse $A_0$. La sortie 2 du registre R.ADQ est reliée à l'entrée 1 du soustracteur 11. Le registre 10 est aussi un registre à décalage à 9 bascules piloté lui aussi par les signaux d'horloge sortant de la porte ET 8 et émis sur son entrée $C_K$. Ce registre est chargé à l'initialisation par le nombre 3 à l'aide de deux interrupteurs $I_1$ et $I_2$. Sa sortie 2 est reliée à l'entrée 2 du soustracteur 11. La sortie 2 du registre 10 est rebouclée sur son entrée 1 de manière qu'en cours de décalage les bits de sortie se retrouveront réinjectés à son entrée. Le soustracteur 11 opère la soustraction bit à bit des contenus du registre R.ADQ 9 et du registre 10, le résultat qui apparaît sur sa sortie 3 est réinjecté à l'entrée 1 du registre R.ADQ. De cette façon, le registre R.ADQ contient à la fin de l'opération de soustraction la valeur de l'adresse de début d'opération diminuée de 3 unités. Le comparateur 12 signale sur sa sortie 3 que le contenu du registre R.ADQ est inférieur au nombre décimal 3. Ce comparateur est relié par son entrée 1 à la sortie du registre R.ADQ et sur son entrée 2 à un organe 16 délivrant sur sa sortie 1 la combinaison binaire 000.000.011 correspondant au nombre décimal 3. La sortie 3 du comparateur 12 est appliquée d'une part à l'entrée 3 de la porte ET 8 et d'autre part à l'entrée 1 de l'inverseur 13 dont la sortie 2 est reliée aux entrées de validation du décodeur de position 3 et du décodeur d'adresse mémoire D.ADM 4. La porte ET 8 reçoit sur son entrée 1 les signaux délivrés par le générateur d'horloge 7 et sur son entrée 2 le signal « start » qui commande toute l'opération d'adressage. La mémoire 1 est reliée à un registre de données R.D2 qui contient les informations à écrire ou à lire dans la mémoire à l'adresse calculée par les moyens d'adressage. Ce registre est relié aux organes extérieurs par la ligne de données D0. La mémoire 1 et le registre R.D sont commandés en écriture et en lecture par les signaux E et L.

Le fonctionnement du dispositif fait à l'aide du chronogramme de la figure 5 est le suivant. A l'initialisation, l'adresse du caractère témoin est introduite en binaire dans le registre R.ADQ 9 ainsi qu'est introduit le nombre décimal 3 dans le registre 10. L'initialisation étant terminée, le calcul d'adresse est alors effectué par application du signe « start » sur l'entrée 2 de la porte ET 8.

L'ensemble constitué par le registre R.ADQ 9, le registre 10 et le soustracteur 11 effectue l'opération ADQ = ADQ − 3 toutes les 9 impulsions d'horloge. En même temps toutes les 9 impulsions d'horloge le compteur C.ADM progresse d'un pas. Ce cycle se poursuit jusqu'à ce que le contenu du registre R.ADQ devienne inférieur au nombre décimal 3. Lorsque cette condition est réalisée le compteur C.ADM contient l'adresse ligne de l'emplacement mémoire recherché et le registre R.ADQ contient la position (POS) de cet emplacement. L'écriture du caractère témoin à l'emplacement ainsi sélectionné peut alors avoir lieu en envoyant sur la ligne E un nombre déterminé de « tops » d'écriture durant l'intervalle séparant la fin du calcul de l'adresse jusqu'à la retombée du signal « start ». De cet intervalle dépend naturellement la durée du temps de charge des cellules de mémoire composant le caractère témoin et par la même sa fragilité.

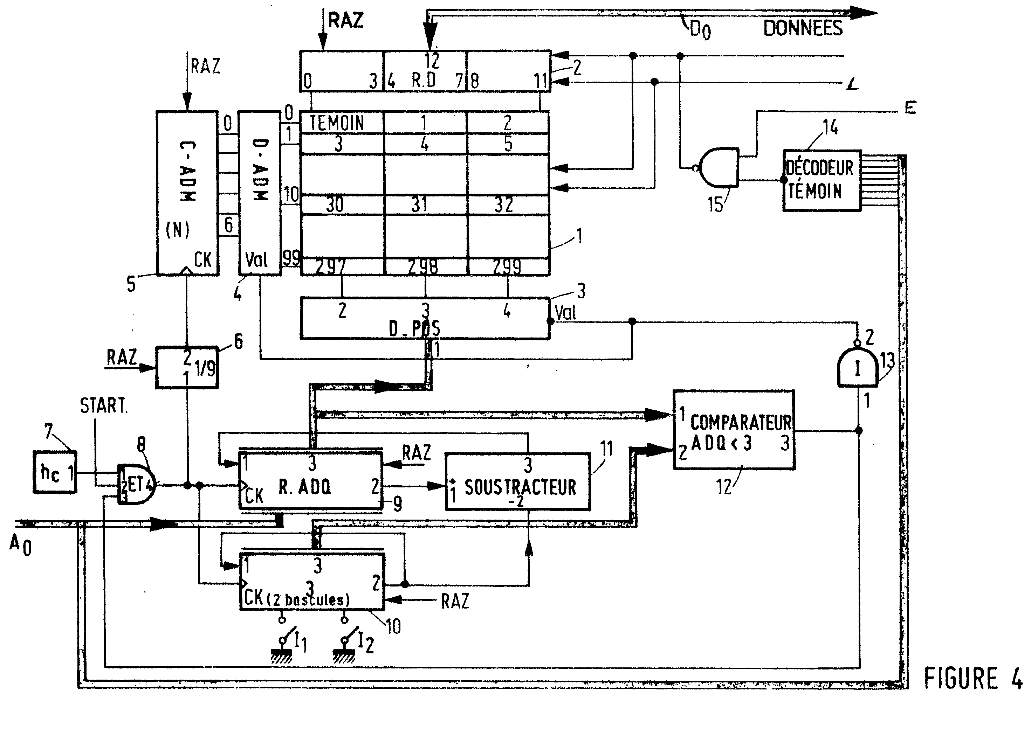

L'introduction du caractère témoin dans la mémoire à lieu en fabrication avant l'assemblage du module de mémoire avec le restant des circuits qui devront, lorsque le produit sera fini, coopérer avec cette mémoire. Il est nécessaire, lorsque le produit sera fini, d'interdire des écritures d'information intempestives à l'intérieur de la zone témoin. La figure 4 montre le dispositif qui devra nécessairement être ajouté au cours de fabrication au circuit d'adressage de la mémoire et après inscription du caractère témoin. Il se compose du décodeur 14 et de la porte « NON ET 15 ». Les entrées du décodeur 14 sont reliées à la ligne d'adresse $A_0$, sa sortie est reliée à une entrée de la porte « NON ET 15 » à 2 entrées dont l'autre entrée de la porte « NON ET 15 » à 2 entrées dont l'autre entrée reçoit le signal d'écriture E et dont la sortie place le registre de donnée RD et la mémoire 1 en mode « écriture ». Ainsi, lorsqu'apparaît sur la ligne d'adresse $A_0$ une combinaison binaire correspondant à celle définissant l'adresse du caractère témoin, l'écriture dans la mémoire et dans le registre RD2 se trouve interdite. Ce dispositif interdit donc l'écriture dans la zone témoin mais n'empêche pas la lecture de cette zone.

Sur la figure 4, les circuits d'adressage déjà mentionnés au cours de la description de la figure 3 ont été à nouveau représentés. En effet, rien ne s'oppose à réutiliser les mêmes circuits d'adressage pour la confection du produit que ceux utilisés en cours de fabrication pour l'inscription du caractère témoin.

Il résulte de la description d'un exemple de réalisation préféré de l'invention que le problème de la détection d'une modification d'information à des perturbations physiques, tels qu'une exposition à un rayonnement électromagnétique ou suite à des accès répétés à ces mêmes informations, est résolu par le dispositif de l'invention. De même on peut se rendre compte que le dispositif de l'invention peut aussi être utilisé pour le contrôle de l'intégrité des informations mémorisées dans ces mémoires lorsque ces mémoires ont subi une longue période de stockage par exemple dans les magasins d'un centre de traitement de l'information.

## Revendications

1. Procédé d'inscription d'un caractère témoin dans une mémoire (1) composée de cellules de stockage de charges électriques, caractérisé en ce qu'il consiste au cours de la fabrication des circuits devant coopérer avec ladite mémoire, à partager l'espace de la mémoire en au moins deux zones dont l'une est destinée à recevoir un caractère témoin, à charger un nombre déterminé de cellules à stockage de charge composant la zone témoin d'une quantité d'électricité inférieure ou égale à celle utilisée pour l'écriture des informations binaires dans la ou les autres zones, puis à isoler la zone affectée au caractère témoin des circuits d'écriture de la mémoire en interposant entre les moyens de commande de la mémoire et la mémoire des moyens autorisant l'accès du caractère témoin en lecture et l'interdisant en écriture.

2. Procédé selon la revendication 1, caractérisé en ce que le chargement des cellules de stockage composant la zone témoin s'effectue en deux phases, une première phase consistant à sélectionner l'adresse de la zone de stockage du caractère témoin et une deuxième phase consistant à charger d'une quantité d'électricité déterminée les cellules de la zone réservée au caractère témoin.

3. Procédé selon la revendication 1 ou 2, caractérisé en ce que le chargement d'une quantité d'électricité déterminée des cellules mémoires de la zone réservée au caractère témoin s'effectue par commandes successives répétées des circuits d'écriture de ladite mémoire.

4. Procédé selon la revendication 1 ou 2, caractérisé en ce que les moyens autorisant l'accès du caractère témoin en lecture et l'interdisant en écriture se composent d'un décodeur (14) de l'adresse du caractère témoin dont la sortie invalide la commande d'écriture de la mémoire lorsque l'adresse de la zone témoin est présente à l'entrée des circuits (9) d'adressage de la mémoire.

5. Dispositif comprenant une mémoire composée de cellules de stockage de charges électriques, caractérisé en ce que l'espace mémoire est partagé en au moins deux zones dont l'une reçoit un caractère témoin, chaque cellule à stockage de charge composant la zone témoin étant chargée d'une quantité d'électricité égale ou inférieure à celle utilisée pour l'écriture des informations binaires dans la ou les autres zones, et en ce qu'il comprend en outre des moyens (14) pour autoriser l'accès en lecture à la zone réservée au caractère témoin et à l'interdire en écriture, lesdits moyens autorisant l'accès au caractère témoin étant disposés entre les moyens de commande de la mémoire et la mémoire (1).

6. Dispositif selon la revendication 5, caractérisé en ce que les moyens d'autorisation d'accès au caractère témoin se composent d'un décodeur (14) invalidant la commande d'écriture de la mémoire lorsque l'adresse de la zone témoin est présente à l'entrée des circuits d'adressage (9) de la mémoire (1).

## Claims

1. Method of writing a tagging character into a memory (1) formed by cells for storing electrical charges, characterised in that it consists, during the production of the circuits scheduled to cooperate with the said memory, in dividing the memory space into at least two regions of which one is intended to receive a tagging character, in charging a particular number of cells for charge storage forming the tagging region with a quantity of electricity which is smaller than or equal to that utilised to write binary data into the other region or regions, then in isolating the region allocated to the tagging character from the write circuits to the memory by interposing between the memory control means and the memory such means as to authorise access to the tagging character in the read mode and preventing said access in the write mode.

2. Method according to claim 1, characterised in that the charging of the storage cells forming the tagging region is performed in two stages, a first stage consisting in selecting the address of the tagging character storage region and a second stage consisting in charging the cells of the region set aside for the tagging character with a particular quantity of electricity.

3. Method according to claim 1 or 2, characterised in that the charging with a particular quantity of electricity of the memory cells of the region set aside for the tagging character is performed by means of repeated successive actuations of the write circuits of the said memory.

4. Method according to claim 1 or 2, characterised in that the means of authorising access to the tagging character in the read mode and preventing said access in the write mode comprise a decoder (14) of the address of the tagging character of which the output invalidates the write instruction to the memory when the address of the tagging region is present at the input of the memory addressing circuits (9).

5. Device comprising a memory formed of cells for storage of electrical charages, characterised in that the memory space is divided into at least two regions of which one receives a tagging character, each charge storage cell forming the tagging region being charged with a quantity of electricity equal to or smaller than that utilised for writing binary data in the other region or regions, and in that it also comprises means (14) for authorising access in the read mode to the region allocated to the tagging character and of preventing said access in the write mode, the said means of authorising access to the tagging character being situated between the memory control means and the memory (1).

6. Device according to claim 5, characterised in that the means for authorising access to the tagging character comprise a decoder (14) invalidating the write instruction to the memory when the address of the tagging region is present at the input of the addressing circuits (9) of the memory (1).

## Ansprüche

1. Verfahren zum Einschreiben eines Kontrollzeichens in einen Speicher (1), der aus Zellen zum Speichern von elektrischen Ladungen aufgebaut ist, dadurch gekennzeichnet, daß während der Herstellung der zum Zusammenwirken mit den Speicher bestimmten Schaltungen der Speicherraum in wenigstens zwei Zonen geteilt wird, wovon die eine zur Aufnahme eines Kontrollzeichens bestimmt ist, eine bestimmte Anzahl von Ladungsspeicherzellen, aus denen die Kontrollzone gebildet ist, mit einer Elektrizitätsmenge geladen wird, die geringer als oder gleich wie diejenige ist, welche zum Einschreiben von Binärinformationen in der bzw. in den anderen Zonen verwendet wird, und anschließend die dem Kontrollzeichen zugeordnete Zone von den Schreibschaltungen des Speichers isoliert wird, indem zwischen den Steuermitteln des Speichers und dem Speicher Mittel eingefügt werden, welche den Zugang zu dem Kontrollzeichen beim Lesen zulassen und beim Schreiben sperren.

2. Verfahren nach Anspruch 1, dadurch gekennzeichnet, daß das Einspeichern in die Speicherzellen der Kontrollzone in zwei Phasen erfolgt, wovon die erste Phase darin besteht, daß die Adresse der Speicherzone des Kontrollzeichens selektiert wird, und die zweite Phase darin besteht, daß eine bestimmte elektrische Menge in die Zellen der für das Kontrollzeichen reservierten Zone eingeschrieben wird.

3. Verfahren nach Anspruch 1 oder 2, dadurch gekennzeichnet, daß das Einschreiben einer bestimmten elektrischen Menge in die Speicherzellen der für das Kontrollzeichen reservierten Zone durch aufeinanderfolgende wiederholte Steuerbefehle der Schreibschaltungen des Speichers erfolgt.

4. Verfahren nach Anspruch 1 oder 2, dadurch gekennzeichnet, daß die den Zugang zu dem Kontrollzeichen beim Auslesen freigebenden Mittel, die den Zugang beim Schreiben sperren, aus einem Decoder (14) zum Decodieren der Adresse des Kontrollzeichens gebildet sind, dessen Ausgang den Schreibbefehl des Speichers sperrt, wenn die Adresse der Kontrollzone am Eingang der Speicheradressierschaltungen (9) vorhanden ist.

5. Vorrichtung mit einem Speicher, der aus Zellen zum Speichern von elektrischen Ladungen aufgebaut ist, dadurch gekennzeichnet, daß der Speicherraum in wenigstens zwei Zonen unterteilt ist, wovon die eine ein Kontrollzeichen aufnimmt, wobei jede Ladungsspeicherzelle, aus denen die Kontrollzone gebildet ist, mit einer elektrischen Menge geladen wird, die gleich der oder geringer als diejenige ist, die zum Einschreiben von Binärinformationen in die andere bzw. anderen Zonen verwendet wird, und daß sie ferner Mittel (14) zum Freigeben des Lesezugriffs auf die für das Kontrollzeichen reservierte Zone und zum Sperren des Schreibzugriffs auf diese umfaßt, wobei diese den Zugriff zu dem Kontrollzeichen freigebenden Mittel zwischen der Steuereinrichtung des Speichers und dem Speicher (1) angeordnet sind.

6. Vorrichtung nach Anspruch 5, dadurch gekennzeichnet, daß die Mittel zum Freigeben des Zugriffs zu dem Kontrollzeichen aus einem Decoder (14) gebildet sind, welcher den Schreibbefehl des Speichers sperrt, wenn die Adresse der Kontrollzone am Eingang der Adressierschaltungen (9) des Speichers (1) vorhanden ist.

FIGURE 1

FIGURE 5

FIGURE 2A

FIGURE 2B

FIGURE 2C

FIGURE 3

FIGURE 4